# EUROPEAN PATENT SPECIFICATION

(11) **EP 3 527 998 B1**
(45) Date of publication and mention of the grant of the patent: **05.06.2024**
(21) Application number: 17860592.9
(22) Date of filing: 14.09.2017
(51) Int. Cl.: G01R 31/26, G01J 1/02, G01J 1/04

(54) **TEST APPARATUS AND METHOD FOR TESTING A LIGHT-EMITTING DEVICE**
TESTVORRICHTUNG UND VERFAHREN ZUM TESTEN EINER LICHTEMITTIERENDEN VORRICHTUNG
APPAREIL D'ESSAI ET PROCÉDÉ D'ESSAI D'UN DISPOSITIF ÉMETTEUR DE LUMIÈRE

(30) Priority: 11.10.2016 JP 2016200383
(43) Date of publication of application: 21.08.2019
(73) Proprietor: Nikkiso Co., Ltd., Tokyo 150-6022 (JP)
(72) Inventor: NIIZEKI Shoichi, Hakusan-shi Ishikawa 924-0004 (JP); ICHINOKURA Hiroyasu, Hakusan-shi Ishikawa 924-0004 (JP)
(74) Representative: Algemeen Octrooi- en Merkenbureau B.V.
(86) International application number: PCT/JP2017/033218
(87) International publication number: WO 2018/070179

(56) References cited:
- EP-A2- 0 628 830
- EP-A2- 1 213 567
- WO-A1-03/091676
- WO-A1-2014/020978
- WO-A1-2014/020978
- WO-A1-2015/107657
- DE-A1-102013 218 062
- JP-A- H0 750 331
- JP-A- 2002 296 115
- JP-A- 2011 237 350
- JP-A- 2013 174 546
- JP-U- H 072 933
- US-A1- 2007 146 889

## Description

### [TECHNICAL FIELD]

The present invention relates to test devices for light emitting devices according to the preamble of claim 1 and a method for testing light emitting devices according to the preamble of claim 6.

### [BACKGROUND ART]

Light emitting devices such as LEDs are evaluated for reliability in a current-carrying test performed for a long period of time. The test device for performing a current-carrying test like this is exemplified by a test device capable of testing a semiconductor light emitting device in an environment of a temperature lower or higher than the room temperature, without mounting a light component carrying the semiconductor light emitting device on a substrate, etc. (see, for example, patent document 1).
[patent document 1] JP2011-237350
[patent document 2] DE 10 2013 218 062 discloses a further test device for light emitting devices;

### [PROBLEM TO BE SOLVED BY THE INVENTION]

In the case of testing a light emitting device capable of outputting light such as deep ultraviolet light having a short wavelength and a high energy, the light receiving device provided in the test device may be degraded due to the high-energy light, which may result in a failure to properly perform a current-carrying test for a long period of time. This has a consequence of detracting from the reliability of the testing step.

In this background, one illustrative purpose of the present invention is to provide a test device capable of performing a highly reliable continuous current-carrying test.

### [MEANS TO SOLVE THE PROBLEM]

A test device according to an embodiment includes the features of claim 1. Further preferred embodiments are disclosed in the dependent claims.

A method for testing light emitting devices is disclosed in claim 6.

### [ADVANTAGE OF THE INVENTION]

According to the present invention, a highly reliable current-carrying test is provided.

### [BRIEF DESCRIPTION OF THE DRAWINGS]

Fig. 1 schematically shows a configuration of a test device according to the embodiment; and
Fig. 2 is a graph schematically showing the intensity distribution of light output from the light guide.

### [MODE FOR CARRYING OUT THE INVENTION]

A detailed description will be given of embodiments of the present invention with reference to the drawings. Like numerals are used in the description to denote like elements and a duplicate description is omitted as appropriate.

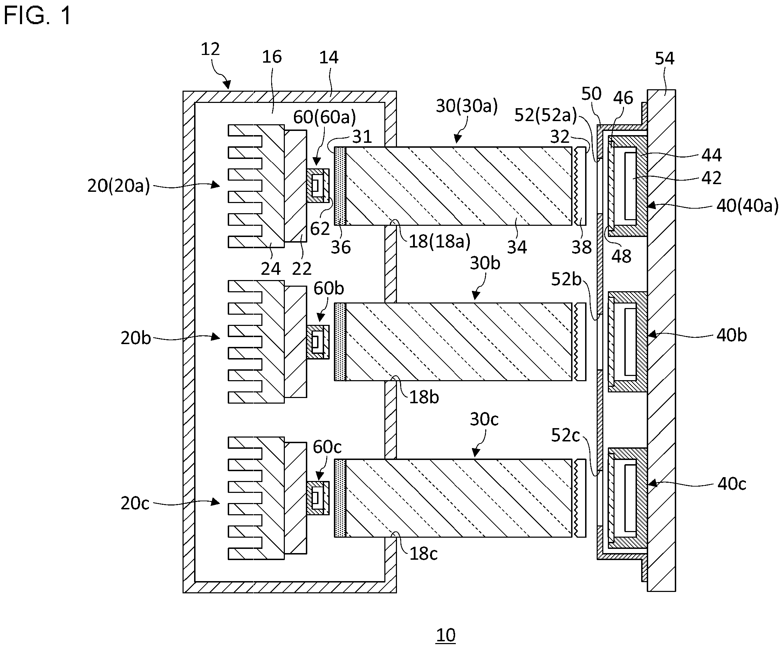

Fig. 1 schematically shows a configuration of a test device 10 according to the embodiment. The test device includes a constant-temperature device 12, a plurality of supports 20 (20a, 20b, 20c), a plurality of light guides 30 (30a, 30b, 30c), a plurality of light receiving devices 40 (40a, 40b, 40c), and a shield plate 50. The test device 10 is a device for performing a current-carrying test of a plurality of light emitting devices 60 (60a, 60b, 60c) collectively.

The light emitting device 60 tested is an ultra violet-light emitting diode (UV-LED) for outputting deep ultraviolet light. The light emitting device 60 is configured to output deep ultraviolet light having a peak wavelength or a central wavelength in a range 200 nm ~ 360 nm. Such a deep ultraviolet LED is exemplified by an aluminum gallium nitride (AlGaN) based LED.

The constant-temperature device 12 includes a container 14 that houses inside the plurality of supports 20 and the light emitting devices 60 respectively supported by the plurality of supports 20. The constant-temperature device 12 is a device exemplified by a constant-temperature tank that heats or cools an interior space 16 bounded by the container 14 to be maintained at a constant temperature. The constant-temperature device 12 maintains the temperature condition used in the current-carrying test of the light emitting device 60 to be maintained over a predetermined test period. The constant-temperature device 12 may be configured to perform a cycle test in which the temperature is increased and decreased at a predetermined period. The container 14 is provided with a plurality of mounting holes 18 (18a, 18b, 18c) for guiding the plurality of light guides 30 therethrough.

The support 20 supports the light emitting device 60 under test. The support 20 includes a substrate 22 for carrying the light emitting device and a heat sink 24. The substrate 22 for carrying the light emitting device includes a terminal connected to the electrode of the light emitting device 60 and supplies a drive current for driving the light emitting device 60 via the terminal. The substrate 22 for carrying the light emitting device is connected to an external electrode (not shown). The heat sink 24 is attached to the substrate 22 for carrying the light emitting device. The heat sink 24 helps the temperature of the substrate 22 for carrying the light emitting device and the light emitting device 60 to be equal to the temperature in the interior space 16 of the constant-temperature device 12.

The plurality of supports 20 are provided inside the constant-temperature device 12. In the illustrated example, three supports 20 are provided, but the number of supports 20 may be two or less or four or more. The plurality of supports 20 may be arranged in a row (one-dimensional array) or arranged in a matrix (two-dimensional array) inside the constant-temperature device 12. In one embodiment, the plurality of supports 20 may be arranged in a matrix of 5x15. In the illustrated example, the support 20 is configured to support one light emitting device 60. In a variation, one support may be configured to support a plurality of light emitting devices 60. For example, the plurality of supports 20a, 20b, and 20c may be integrated so that the one support may carry three light emitting devices 60.

The support 20 is arranged such that the output light from the light emitting device 60 carried on the support 20 is incident on the associated light guide 30. The support 20 is arranged such that a light emission surface 62 of the light emitting device 60 carried by the support 20 faces a light incidence end 31 of the light guide 30, and, preferably, such that the light emission surface 62 of the light emitting device 60 is proximate to the light incidence end 31 of the light guide 30. The support 20 is housed inside the constant-temperature device 12 when the test device 10 is used, but the support 20 may be configured so that it can be easily taken outside the constant-temperature device 12 when the test device 10 is not used. For example, the support 20 may be configured such that it can be housed in a rack provided inside the constant-temperature device 12.

The light guide 30 is provided between the light emitting device 60 and the light receiving device 40 associated with the light guide 30 and is configured to guide the output light from the light emitting device 60 to the light receiving device 40. The light guide 30 is provided to extract the output light of the light emitting device 60 from inside the constant-temperature device 12 to an area outside. The light incidence end 31 of the light guide 30 is provided inside the constant-temperature device 12 and is positioned near the light emitting device 60 carried on the support 20. Meanwhile, the light emission end 32 of the light guide 30 is provided outside the constant-temperature device 12 and is positioned near a light receiving surface 48 of the light receiving device 40.

The light guide 30 includes a light waveguide 34, a light amount filter 36, and a light diffuser plate 38. The light waveguide 34 is a member extending from the associated light emitting device 60 to the light receiving device 40 in the longitudinal direction. The light waveguide 34 is desirably made of a material not easily degraded by the ultraviolet light output by the light emitting device 60. For example, the light waveguide 34 is made of quartz (SiO₂) glass. The light waveguide 34 is formed by, for example, a columnar quartz glass rod. The light waveguide 34 has a cross-sectional area larger than that of the light emission surface 62 of the light emitting device 60. For example, the dimension (diameter) of the cross-sectional surface is 5 mm or larger. In one embodiment, the diameter of the light waveguide 34 is about 6 mm.

The light waveguide 34 may include a core and a clad such as those of the optical fiber or may be comprised only of a core. The light waveguide 34 may be a hollow tube, a quartz tube, a fluororesin (e.g., polytetrafluoroethylene) tube, or a resin tube or a metal tube having an aluminum inner surface. The shape of the cross-section perpendicular to the longitudinal direction of the light waveguide 34 is not limited to any particular shape. For example, the cross section may be shaped in a circle, ellipse, triangle, quadrangle, pentagon, and hexagon. The light waveguide 34 may be comprised of a bundle of a plurality of optical fibers.

The light amount filter 36 is a so-called neutral density (ND) filter and attenuates the intensity of light transmitted by the light guide 30 by a certain proportion. The transmittance of the light amount filter 36 is not limited to any particular value. For example, values like 1%, 5%, 10%, 20%, etc. can be used. It is preferred that the light amount filter 36 be made of a material that cannot be easily degraded by deep ultraviolet light. For example, quartz glass is used as a base material. Using a material having a high durability against deep ultraviolet light reduces the impact from degradation due to ultraviolet light that causes the filter transmittance to vary with time.

The light amount filter 36 is provided at the light incidence end 31 of the light guide 30 and is provided between the light emitting device 60 and the light waveguide 34. Providing the light amount filter 36 before the light waveguide 34 reduces the impact from high-intensity deep ultraviolet light incident on the light waveguide 34 that degrades the light waveguide 34. In one variation, the light amount filter 36 may be provided between the light waveguide 34 and the light receiving device 40. Specifically, the light amount filter 36 may be provided between the light waveguide 34 and the light diffuser plate 38 or between the light diffuser plate 38 and the light receiving device 40.

The light diffuser plate 38 is provided at the light emission end 32 of the light guide 30. The light diffuser plate 38 diffuses the light output from the light waveguide 34 and conditions the intensity distribution of the light incident on the light receiving device 40. The light diffuser plate 38 makes the intensity distribution of the output light from the light waveguide 34 uniform. In other words, the light diffuser plate 38 lowers the peak intensity value of the output light and enlarges the full width at half maximum value of the intensity distribution. It is preferred that the light diffuser plate 38 be made of a material that is not easily degraded by deep ultraviolet light. For example, quartz glass is used as a base material. The light diffuser plate 38 may be a so-called "frosted glass" and produced by forming fine concavo-convex surfaces for diffusing light on a principal surface of both surfaces a quartz glass plate. For the purpose of light diffusion, it is preferred to form the concavo-convex surfaces to have a uniform and compact sand finish.

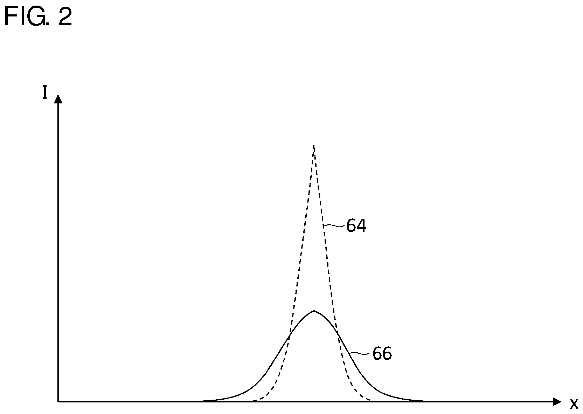

Fig. 2 is a graph schematically showing the intensity distribution of light output from the light guide 30 and shows the distribution of light intensity I in the direction along the light receiving surface 48 (x direction). A broken line 64 shows an example of intensity distribution of light output from the light waveguide 34 in the absence of the light diffuser plate 38. The output light from the light waveguide 34 exhibits an intensity distribution having a strong peak near the center, i.e., an intensity distribution as illustrated having a sharp peak and a small spread. A solid line 66 indicates an example of intensity distribution of light output from the light guide 30 in the presence of the light diffuser plate 38. By transmitting the light through the light diffuser plate 38, diffused light with an intensity distribution having a lower peak intensity and a lager spread than those indicated by the broken line 64 is output.

The light receiving device 40 is provided outside the constant-temperature device 12 and receives the light transmitted by the light guide 30. Each of the light receiving devices 40 receives the light output from the associated light emitting device 60. For example, the first light receiving device 40a receives the light output from the first light emitting device 60a and transmitted by the first light guide 30a. Similarly, the second light receiving device 40b receives the light output from the second light emitting device 60b and transmitted by the second light guide 30b, and the third light receiving device 40c receives the light output from the third light emitting device 60c and transmitted by the third light guide 30c. The plurality of light receiving devices 40 are attached to a substrate 54 for carrying the light receiving device.

The light receiving device 40 includes a light receiving element 42, a package 44, and a light receiving window 46. The light receiving element 42 is a photoelectric conversion element such as a photodiode and measures the intensity of incident light. The light receiving element 42 may be configured to measure the intensity distribution of incident light. The light receiving element 42 is housed inside the package 44. The light receiving window 46 transmits the light traveling toward the light receiving element 42. The light receiving window 46 is attached to the package 44. The light receiving window 46 and the package 44 seal the light receiving element 42 inside the package 44. For example, the light receiving window 46 is attached to the package 44 by an adhesive provided on the outer periphery of the light receiving window 46. The light receiving window 46 forms the light receiving surface 48 on which the light that should be measured by the light receiving device 40 is incident.

The shield plate 50 is provided between the light guide 30 and the light receiving device 40. The shield plate 50 has a plurality of openings 52 (52a, 52b, 52c) that transmit the light traveling toward the central area of the light receiving surfaces 48 of the plurality of light receiving devices 40 (40a, 40b, 40c). The opening 52 has a shape corresponding to the shape of the light receiving surface 48 of the light receiving device 40. For example, the opening 52 is shaped in a circle or a rectangle. The shield plate 50 transmits the light traveling toward the central area of the light receiving surface 48 of the light receiving device 40 but shields the light traveling toward the outer periphery of the light receiving surface 48. This prevents the adhesive agent bonding the package 44 and the light receiving window 46 from being irradiated with deep ultraviolet light and degraded so as to detract from the sealing performance of the package 44.

A description will now be given of a method of using the test device 10. First, the light emitting device 60 is carried on each of the plurality of supports 20. The interior of the constant-temperature device 12 is set to a predetermined temperature and the light emitting device 60 is lighted. The deep ultraviolet light emitted by the light emitting device 60 has its intensity attenuated by the light amount filter 36 and is transmitted by the light waveguide 34. The light diffuser plate 38 uniformizes the intensity distribution. The light receiving device 40 receives the light transmitted by the light guide 30. The light emitting device 60 is caused to carry a current continuously for a period of time necessary for the test (e.g., 100 hours, 1000 hours, 5000 hours, 10000 hours, 50000 hours). The light receiving device 40 measures the intensity or intensity distribution of the incident light over the period of time for which the continuous current-carrying test is performed.

According to the embodiment, a current-carrying test of the light emitting device 60 outputting deep ultraviolet light is performed, while suitably preventing degradation of the light guide 30 and the light receiving device 40 due to the deep ultraviolet light. Ultraviolet light having a wavelength of 360 nm or shorter has a high light energy (3.4 eV or higher). Therefore, the material used in the light guide 30 and the light receiving device 40 in the relate-art test device configuration are damaged, damaging the light guide 30 and the light receiving device 40. If an ordinary optical glass or resin material is used as a material of the light guide 30, for example, the light guide 30 is degraded by the impact from deep ultraviolet light, resulting in optical materials turning yellow and/or brittle. Further, a semiconductor material like silicon (Si) used in the light receiving element 42 may be degraded when receiving a high-intensity deep ultraviolet light and could not be used continuously for a long period of time. For example, our experiment with measurement of the output light from the light emitting device 60 of a wavelength 300 nm and an optical output of 30 mW without the light amount filter 36 nor the light diffuser plate 38 revealed that, after about 1000 hours, the neighborhood of the center of the light receiving element 42 turns black and the light intensity can no longer be measured accurately. Meanwhile, it was found out that the use of a combination of the light amount filter 36 with a transmittance of 10% and the light diffuser plate 38 with #220 sand finish extends the life of the light receiving device 40 to about 50000 hours. Therefore, the test device 10 according to the embodiment makes it possible to perform a continuous current-carrying test for long period of time and enhance the reliability of the life test of the light emitting device 60.

According to the embodiment, the light receiving device 40 is provided outside the constant-temperature device 12 so that the light receiving device 40 of a specification for the operation under room temperature can be used. This eliminates the necessity of preparing a special light receiving device 40 that can be operated in a low or high temperature so that the cost for the light receiving device 40 is reduced. The test device is configured such that the shield plate 50 protects the joint between the package 44 of the light receiving device 40 and the light receiving window 46 so that there is no need to use a light receiving device 40 of a specification for high resistance to light and the cost of the light receiving device 40 is reduced accordingly.

According to the embodiment, the light output from the light waveguide 34 and having a high peak intensity is diffused by using the light diffuser plate 38 before being received by the device. It is therefore possible for the light receiving device 40 to make a highly sensitive measurement by taking full advantage of the effective area capable of receiving light. This enhances the reliability of the light emission test using the test device 10.

A description will now be given of a method of manufacturing the light emitting device 60 including a testing step that uses the test device 10. First, a semiconductor light emitting device formed by an aluminum gallium nitride (AlGaN) based semiconductor material is fabricated, and the light emitting device 60 is manufactured by sealing the light emitting device thus fabricated in an LED package. Subsequently, a lighting test of the light emitting device 60 is performed by using the test device 10. In a light emitting test, the light output from the light emitting device 60 is received by the light receiving device 40 via the light amount filter 36, the light waveguide 34, and the light diffuser plate 38 to test the optical output of the light emitting device 60. The testing step may be a burn-in test in which a current is carried for a predetermined period of time in a high-temperature environment in order to stabilize the characteristics and eliminate irregular products or defective products. The light emitting device 60 may be completed by undergoing a burn-in test. In this manufacturing method, the test is performed by using the test device 10 that is not easily affected by deep ultraviolet light so that the reliability of the testing step is enhanced, and the reliability of the light emitting device 60 shipped is enhanced.

Described above is an explanation based on an exemplary embodiment. The embodiment is intended to be illustrative only and it will be understood by those skilled in the art that various design changes are possible and various modifications are possible and that such modifications are also within the scope of the present invention.

In the above embodiment, the test device 10 is described as using one constant-temperature device 12. In one variation, the test device 10 may be provided with a plurality of constant-temperature devices 12. The plurality of constant-temperature devices 12 may be arranged in a row or arranged in a matrix (e.g., 2x2). The plurality of supports 20 may be provided in each of the plurality of constant-temperature devices 12. By using a plurality of constant-temperature devices 12, tests with different temperature conditions can be performed at the same time to increase the efficiency of tests.

In the above embodiment, the case of testing the light emitting device 60 for outputting deep ultraviolet light has been described. In one variation, the test device 10 described above may be used for a light emitting device for outputting light other than deep ultraviolet light. For example, a light emitting device for outputting ultraviolet light of 360 nm ~ 400 nm or a light emitting device for outputting blue light of 400 nm ~ 450 nm may be tested. Light emitting devices for outputting visible light such as green light, yellow light, and red light may be tested, or light emitting devices for outputting infrared light may be tested.

### [DESCRIPTION OF THE REFERENCE NUMERALS]

10 ... test device, 12 ... constant-temperature device, 20 ... support, 30 ... light guide, 34 ... light waveguide, 36 ... light amount filter, 38 ... light diffusion plate, 40 ... light receiving device, 48 ... light receiving surface, 50 .... shield plate, 60 ... light emitting device

### [INDUSTRIAL APPLICABILITY]

According to the present invention, a highly reliable current-carrying test is provided.

## Claims

1. A test device (10) comprising:
one or a plurality of supports (20, 20a, 20b, 20c) that supports a plurality of light emitting device (60, 60a, 60b, 60c) subject to a test;
a plurality of light waveguides (34) that guides light output from the plurality of light emitting device (60, 60a, 60b, 60c) supported by the one or plurality of supports (20, 20a, 20b, 20c);
a plurality of light diffuser plates (38) that respectively diffuses light output from the plurality of light waveguides (34);
a plurality of light receiving devices (40) that respectively receives light diffused by the plurality of diffuser plates (38);
a shield plate (50), between the plurality of light waveguides (34) and the plurality of light receiving devices (40), wherein the shield plate (50) has a plurality of openings, each of the plurality of openings arranged to transmit light toward a central area of a light receiving surface (48) of an associated light receiving device (40, 40a, 40b, 40c) and to shield light traveling to an outer periphery of the associated light receiving device (40, 40a, 40b, 40c);
wherein each of the plurality of light receiving devices (40) comprises a light receiving element (42); a package (44) in which the light receiving element (42) is housed; and a light receiving window (46) arranged to cover the light receiving element (42) and being attached to the package (44) by an adhesive provided on the outer periphery of the light receiving window (46), the light receiving element (42) being sealed inside the package (44) by the package (44) and the light receiving window (46), the light receiving window (46) forming the light receiving surface (48) on which the light that should be measured by the light receiving device (40) is incident,
each of plurality of light emitting devices (60a, 60b, 60c) being arranged to output deep ultraviolet light having a wavelength of 360 nm or shorter;
the shield plate (50) is provided to shield light travelling towards the adhesive of each of the plurality of light receiving device (60).

2. The test device according to claim 1, further comprising:
a constant-temperature device (12) that houses the one or plurality of supports (20, 20a, 20b, 20c) and the plurality of light emitting devices (60, 60a, 60b, 60c) supported by the one or plurality of supports (20, 20a, 20b, 20c) inside and controls an operating temperature of the plurality of light emitting devices (60, 60a, 60b, 60c), wherein
the plurality of light receiving devices (40, 40a, 40b, 40c) is provided outside the constant-temperature device (12), and the plurality of light waveguide (34) guides light from inside the constant-temperature device (12) to an area outside the constant-temperature device.

3. The test device according to claim 1 or 2, wherein:
each of the plurality of light waveguides (34) is formed by a rod of quartz glass.

4. The test device according to claim 3, wherein:
each of the plurality of light waveguides (34) has a cross sectional area larger than an area of a light emission surface of an associated light emitting devices (60, 60a, 60b, 60c).

5. The test device according to any one of claims 1 through 4, wherein:
each of the light diffuser plates (38) is a quartz glass plate having a concavo-convex surface for diffusing light.

6. A method of testing a light emitting device (60) using the test device according to any of claims 1 through 5, the method comprising the steps of:
receiving light output from a light emitting device (60) by a light receiving device (40) via a light waveguide (34) and a light diffuser plate (38) and
testing an optical output of the light emitting device (60), and
providing, prior to the step of receiving light output from the light emitting device (60), a shield plate (50), between the light waveguide (34) and the light receiving device (4), wherein the shield plate (50) has a plurality of openings, each of the plurality of openings arranged to shield light output from a light emitting device (60) travelling toward an outer peripheral area of a light receiving surface (46) of a light receiving device (40).

## Patentansprüche

1. Prüfvorrichtung (10), die Folgendes umfasst:
einen oder mehrere Halter (20, 20a, 20b, 20c), die mehrere lichtemittierende Vorrichtungen (60, 60a, 60b, 60c) halten, die einer Prüfung ausgesetzt sind;
mehrere Lichtwellenleiter (34), die Licht leiten, das von den mehreren lichtemittierenden Vorrichtungen (60, 60a, 60b, 60c), die durch den einen oder die mehreren Halter (20, 20a, 20b, 20c) gehalten werden, ausgegeben wird;
mehrere Lichtstreuscheiben (38), die jeweils von den mehreren Lichtleitern (34) ausgegebenes Licht zerstreuen;
mehrere Lichtempfangsvorrichtungen (40), die jeweils durch die mehreren Streuscheiben (38) zerstreutes Licht empfangen;
eine Abschirmplatte (50) zwischen den mehreren Lichtwellenleitern (34) und den mehreren Lichtempfangsvorrichtungen (40), wobei die Abschirmplatte (50) mehrere Öffnungen aufweist, wobei jede der mehreren Öffnungen dafür ausgelegt ist, Licht in Richtung eines zentralen Bereichs einer Lichtempfangsfläche (48) einer zugeordneten Lichtempfangsvorrichtung (40, 40a, 40b, 40c) durchzulassen und zu einem Außenumfang der zugeordneten Lichtempfangsvorrichtung (40, 40a, 40b, 40c) laufendes Licht abzuschirmen;
wobei jede der mehreren Lichtempfangsvorrichtungen (40) ein Lichtempfangselement (42); ein Gehäuse (44), in dem das Lichtempfangselement (42) aufgenommen ist; und das Lichtempfangsfenster (46), das so angeordnet ist, dass es das Lichtempfangselement (42) bedeckt und durch einen an dem Außenumfang des Lichtempfangsfensters (46) vorgesehenen Klebstoff an dem Gehäuse (44) angebracht ist, umfasst, wobei das Lichtempfangselement (42) innerhalb des Gehäuses (44) durch das Gehäuse (44) und das Lichtempfangsfenster (46) abgedichtet ist, wobei das Lichtempfangsfenster (46) die Lichtempfangsfläche (48) bildet, auf die das Licht, das durch die Lichtempfangsvorrichtung (40) gemessen werden soll, einfällt, wobei jede der mehreren lichtemittierenden Vorrichtungen (60a, 60b, 60c) dafür ausgelegt ist, tief ultraviolettes Licht mit einer Wellenlänge von 360 nm oder kürzer auszugeben;
wobei die Abschirmplatte (50) zum Abschirmen von Licht, das in Richtung des Klebstoffs jeder der mehreren Lichtempfangsvorrichtungen (60) läuft, bereitgestellt ist.

2. Prüfvorrichtung nach Anspruch 1, die ferner Folgendes umfasst:
eine Vorrichtung (12) mit konstanter Temperatur, die den einen oder die mehreren Halter (20, 20a, 20b, 20c) und die mehreren lichtemittierenden Vorrichtungen (60, 60a, 60b, 60c), die durch den einen oder die mehreren Halter (20, 20a, 20b, 20c) gehalten werden, im Inneren aufnimmt und eine Betriebstemperatur der mehreren lichtemittierenden Vorrichtungen (60, 60a, 60b, 60c) steuert,
wobei die mehreren Lichtempfangsvorrichtungen (40, 40a, 40b, 40c) außerhalb der Vorrichtung (12) mit konstanter Temperatur bereitgestellt sind und wobei die mehreren Lichtwellenleiter (34) Licht aus dem Inneren der Vorrichtung (12) mit konstanter Temperatur zu einem Bereich außerhalb der Vorrichtung mit konstanter Temperatur leiten.

3. Prüfvorrichtung nach Anspruch 1 oder 2, wobei:
jeder der mehreren Lichtwellenleiter (34) aus einem Stab aus Quarzglas gebildet ist.

4. Prüfvorrichtung nach Anspruch 3, wobei:
jeder der mehreren Lichtwellenleiter (34) eine größere Querschnittsfläche als eine Fläche einer Lichtempfangsfläche einer zugeordneten Lichtemissionsvorrichtung (60, 60a, 60b, 60c) aufweist.

5. Prüfvorrichtung nach einem der Ansprüche 1 bis 4, wobei:
jede der Lichtstreuscheiben (38) eine Quarzglasplatte mit einer konkavkonvexen Oberfläche zum Zerstreuen von Licht ist.

6. Verfahren zum Prüfen einer lichtemittierenden Vorrichtung (60) unter Verwendung der Prüfvorrichtung nach einem der Ansprüche 1 bis 5, wobei das Verfahren die folgenden Schritte umfasst:
Empfangen einer Lichtausgabe von einer lichtemittierenden Vorrichtung (60) durch eine Lichtempfangsvorrichtung (40) über einen Lichtwellenleiter (34) und eine Lichtstreuscheibe (38) und
Prüfen einer optischen Ausgabe der lichtemittierenden Vorrichtung (60), und
Bereitstellen einer Abschirmplatte (50) zwischen dem Lichtwellenleiter (34) und der Lichtempfangsvorrichtung (4) vor dem Schritt des Empfangens der Lichtausgabe von der lichtemittierenden Vorrichtung (60), wobei die Abschirmplatte (50) mehrere Öffnungen aufweist, wobei jede der mehreren Öffnungen ausgelegt ist zum Abschirmen von von einer lichtemittierenden Vorrichtung (60) ausgegebenem Licht, das in Richtung eines Außenumfangsbereichs einer Lichtempfangsfläche (46) einer Lichtempfangsvorrichtung (40) läuft.

## Revendications

1. Dispositif de test (10) comprenant :
un ou plusieurs supports (20, 20a, 20b, 20c) qui supportent une pluralité de dispositif émetteurs de lumière (60, 60a, 60b, 60c) soumis à un test ;
une pluralité de guides d'ondes de lumière (34) qui guident la lumière émise par la pluralité de dispositifs émetteurs de lumière (60, 60a, 60b, 60c) supportés par le ou les plusieurs supports (20, 20a, 20b, 20c) ;
une pluralité de plaques de diffusion de lumière (38) qui diffusent respectivement la lumière émise par la pluralité de guides d'ondes de lumière (34) ;
une pluralité de dispositifs de réception de lumière (40) qui reçoivent respectivement la lumière diffusée par la pluralité de plaques de diffusion de lumière (38) ;
une plaque de protection (50) entre la pluralité de guides d'ondes de lumière (34) et la pluralité de dispositifs de réception de lumière (40), dans lequel la plaque de protection (50) présente une pluralité d'ouvertures, chacune de la pluralité d'ouvertures étant agencée pour transmettre la lumière vers une zone centrale d'une surface de réception de lumière (48) d'un dispositif de réception de lumière associé (40, 40a, 40b, 40c) et pour bloquer la lumière se déplaçant vers une périphérie extérieure du dispositif de réception de lumière associé (40, 40a, 40b, 40c) ;
dans lequel chacun de la pluralité de dispositifs de réception de lumière (40) comprend un élément de réception de lumière (42) ; un boîtier (44) dans lequel l'élément de réception de lumière (42) est logé ; et une fenêtre de réception de lumière (46) agencée pour couvrir l'élément de réception de lumière (42) et étant fixée au boîtier (44) par un adhésif fourni sur la périphérie extérieure de la fenêtre de réception de lumière (46), l'élément de réception de lumière (42) étant scellé à l'intérieur du boîtier (44) par le boîtier (44) et la fenêtre de réception de lumière (46), la fenêtre de réception de lumière (46) formant la surface de réception de lumière (48) sur laquelle la lumière qui doit être mesurée par le dispositif de réception de lumière (40) est incidente,
chacun de la pluralité de dispositif émetteurs de lumière (60a, 60b, 60c) étant agencé pour émettre une lumière ultraviolette profonde ayant une longueur d'onde inférieure ou égale à 360 nm ;
la plaque de protection (50) est prévue pour bloquer la lumière se déplaçant vers l'adhésif de chacun de la pluralité de dispositifs de réception de lumière (60).

2. Dispositif de test selon la revendication 1, comprenant en outre :
un dispositif à température constante (12) qui loge le ou les plusieurs supports (20, 20a, 20b, 20c) et la pluralité de dispositifs émetteurs de lumière (60, 60a, 60b, 60c) supportés par le ou les plusieurs supports (20, 20a, 20b, 20c) à l'intérieur et commande une température de fonctionnement de la pluralité de dispositifs émetteurs de lumière (60, 60a, 60b, 60c), dans lequel
la pluralité de dispositifs de réception de lumière (40, 40a, 40b, 40c) est prévue à l'extérieur du dispositif à température constante (12), et la pluralité de guides d'ondes de lumière (34) guide la lumière depuis l'intérieur du dispositif à température constante (12) vers une zone à l'extérieur du dispositif à température constante.

3. Dispositif de test selon la revendication 1 ou 2, dans lequel :
chacun de la pluralité de guides d'ondes de lumière (34) est formé par une tige en verre de quartz.

4. Dispositif de test selon la revendication 3, dans lequel :
chacun de la pluralité de guides d'ondes de lumière (34) présente une superficie en coupe plus grande qu'une superficie d'émission de lumière d'un dispositif émetteur de lumière associé (60, 60a, 60b, 60c).

5. Dispositif de test selon l'une quelconque des revendications 1 à 4, dans lequel :
chacune des plaques de diffusion de lumière (38) est une plaque en verre de quartz ayant une surface concavo-convexe pour diffuser la lumière.

6. Procédé de test d'un dispositif émetteur de lumière (60) utilisant le dispositif de test selon l'une des revendications 1 à 5, le procédé comprenant les étapes de :
réception de la lumière émise par un dispositif émetteur de lumière (60) par un dispositif de réception de lumière (40) via un guide d'ondes de lumière (34) et une plaque de diffusion de lumière (38) et
test d'une sortie optique du dispositif émetteur de lumière (60), et
fourniture, avant l'étape de réception de lumière émise par le dispositif émetteur de lumière (60), d'une plaque de protection (50), entre le guide d'ondes de lumière (34) et le dispositif de réception de lumière (40), dans lequel la plaque de protection (50) présente une pluralité d'ouvertures, chacune de la pluralité d'ouvertures étant agencée pour bloquer la lumière émise par un dispositif émetteur de lumière (60) se déplaçant vers une zone périphérique extérieure d'une surface de réception de lumière (46) d'un dispositif de réception de lumière (40).
